# EUROPEAN PATENT APPLICATION

(11) **EP 1 493 837 A1**
(43) Date of publication of application: **05.01.2005**
(21) Application number: 03715740.1
(22) Date of filing: 02.04.2003
(51) Int. Cl.: C23C 14/24

(54) **METHOD AND APPARATUS FOR PREPARING THIN RESIN FILM**

(30) Priority: 05.04.2002 JP 2002104417
(71) Applicant: MATSUSHITA ELECTRIC INDUSTRIAL CO., LTD., Kadoma-shi, Osaka 571-8501 (JP)
(72) Inventor: ECHIGO, Noriyasu, Kobe-shi, Hyogo 657-0024 (JP); SATANI, Hiroshi, Yawata-shi, Kyoto 614-8047 (JP); OKUMURA, Hideki, Ikoma-shi, Nara 630-0243 (JP); TACHIHARA, Hisaaki, Matsue-shi, Shimane 690-0011 (JP)
(74) Representative: VOSSIUS & PARTNER
(86) International application number: PCT/JP2003/004239
(87) International publication number: WO 2003/085157

(57) **Abstract**

A liquid resin material stored in a resin material cup is sent to a supply tank under pressure through a primary side supply pipe by increasing the pressure in a pressure tank. The supply tank is provided with a piston that is displaced in accordance with the amount of the resin material in the supply tank, and the resin material is quantified by the stroke of the piston. The quantified resin material is sent to a heating member through an evaporation side supply pipe, is evaporated by heating, and condenses on a substrate. The resin material is quantified by filling the supply tank with the resin material temporarily, and only the filling resin material is sent to the heating member. Therefore, an evaporation amount becomes constant, and as a result, the thickness of a resin thin film is stabilized.

## Description

### Technical Field

The present invention relates to a method and apparatus for producing a resin thin film used in an electronic component and the like.

### Background Art

Resin thin films play a role in a wide range, and are used in various areas in our daily life, such as magnetic tapes, capacitors, and wrapping films. A method for forming a resin thin film used in these areas may be classified roughly into two types of processes: coating and vacuum film-formation.

According to the coating method, a resin thin film is formed by coating a substrate with a resin material diluted with a solvent. The coating method is preferable for forming a resin thin film in a large area at a high speed. However, when it is attempted to set the thickness of a resin thin film to be 1 µm or less, a number of film defects occur. In contrast, according to the vacuum film-formation method, a resin thin film is formed by allowing a resin material evaporated by heating to adhere to a substrate under vacuum. The vacuum film-formation has productivity inferior to that of the coating method. However, the vacuum film-formation enables the thickness of a resin thin film to be 1 µm or less, so that it is being developed actively in recent years.

JP 11(1999)-209870 A discloses a method for forming a resin thin film, by vacuum film-formation at a high speed with less defects, on the surface of a film substrate running on a cylindrical support or the surface of a flat-shaped substrate moving intermittently.

According to the above method, a plurality of film-forming units, including a resin thin film forming portion for forming a resin thin film by vacuum film-formation and an inorganic thin film forming portion for forming an inorganic thin film by a vacuum process such as vapor deposition, are provided in the same vacuum chamber, whereby a thin film layered product including a resin thin film and an inorganic thin film is formed on a substrate. However, the quality of an inorganic thin film formed by a vacuum process is likely to be influenced by the atmosphere of the forming portion, in particular, the degree of vacuum thereof. In the case where a thin film layered product is formed by providing a resin thin film forming portion and an inorganic thin film forming portion in the same vacuum chamber as described above, the vapor pressure of the resin during film-formation becomes relatively high. Therefore, the degree of vacuum of the inorganic thin film forming portion is degraded due to the resin vapor, which makes it difficult to obtain an inorganic thin film of high quality.

Therefore, in the case where an inorganic thin film as well as a resin thin film are formed on a rectangular flat-shaped substrate or a circular flat-shaped substrate used for a semiconductor panel, a liquid crystal panel, or the like and surface treatment is conducted, while it is required to maintain a high quality atmosphere during formation of the inorganic thin film and surface treatment, the resin thin film forming portion is partitioned from the other portions such as the inorganic thin film forming portion and the surface treatment portion with a gate valve or the like so that the atmospheres in the respective processes do not interfere with each other. Under this condition, a substrate is transported intermittently to the site for each process, whereby film-formation and treatment are conducted. For example, in the case where an inorganic thin film and a resin thin film are formed successively on a substrate, and thereafter, the resin thin film is subjected to surface treatment, the following is required: an inorganic thin film is first formed on a substrate in an inorganic thin film forming portion; a gate valve between the inorganic thin film forming portion and a resin thin film forming portion is opened to transport the substrate to the resin thin film forming portion; a resin thin film is formed; thereafter, a gate valve between the resin thin film forming portion and a surface treatment portion is opened to transport the substrate to the surface treatment portion; and surface treatment is conducted.

As described above, in the case where a resin thin film is formed on a substrate that is being transported intermittently, the substrate stops during formation of the resin thin film. Therefore, there may be problems that are not apparent in the case where a resin thin film is formed on a substrate that is being moved continuously as described in JP 11(1999)-209870 A.

For example, the thickness precision of the resin thin film is substantially determined by managing the degree of an evaporation amount of a resin material. Conventionally, the evaporation amount of the resin material is adjusted by controlling the supply time of a liquid resin material to a heating element, i.e., the open time of a valve provided in a supply tube of the liquid resin material. However, according to this method, the evaporation amount of the resin material tends to be varied; as a result, the thickness of the resin thin film to be formed is likely to become unstable.

### Disclosure of Invention

Therefore, with the foregoing in mind, it is an object of the present invention to solve the above-mentioned problem in the case of forming a rein thin film by vacuum film-formation on a substrate that is being transported intermittently, and provide a method and apparatus for producing a resin thin film with less variation in thickness.

The present invention has the following configuration so as to achieve the above-mentioned object.

A first method for producing a resin thin film of the present invention uses an apparatus for producing a resin thin film including: a heating member for evaporating a liquid resin material by heating; a holder for holding a substrate, upon which the evaporated resin material condenses, at a predetermined position; a vacuum tank housing the heating member, the substrate, and the holder; a primary tank portion including a pressure tank and a resin material cup disposed in the pressure tank and storing the liquid resin material; a supply portion including a supply tank storing the liquid resin material temporarily, and a piston disposed in the supply tank and displaced in correspondence with a volume of the liquid resin material in the supply tank; a primary side supply pipe for sending the liquid resin material from the resin material cup to the supply tank; a primary side valve provided in the primary side supply pipe; an evaporation side supply pipe for sending the liquid resin material from the supply tank to the heating member; and an evaporation side valve provided in the evaporation side supply pipe. The method includes: when the primary side valve is open and the evaporation side valve is closed, increasing a pressure in the pressure tank, thereby sending the liquid resin material in the resin material cup to the supply tank under pressure through the primary side supply pipe; and closing the primary side valve, opening the evaporation side valve, and sending the liquid resin material in the supply tank to the heating member through the evaporation side supply pipe.

Furthermore, a second method for producing a resin thin film of the present invention uses an apparatus for producing a resin thin film including: a heating member for evaporating a liquid resin material by heating; a holder for holding a substrate, upon which the evaporated resin material condenses, at a predetermined position; a vacuum tank housing the heating member, the substrate, and the holder; a primary tank portion including a pressure tank and a resin material cup disposed in the pressure tank and storing the liquid resin material; a supply pipe for supplying the liquid resin material stored in the resin material cup to the heating member; a valve provided in the supply pipe; and a flowmeter for measuring a flow amount of the liquid resin material flowing in the supply pipe. The method includes: increasing a pressure in the pressure tank when the valve is closed; opening the valve and sending the liquid resin material in the resin material cup to the heating member under pressure through the supply pipe; and closing the valve when the flow amount of the liquid resin material obtained by the flowmeter reaches a predetermined value.

Next, a first apparatus for producing a resin thin film of the present invention includes: a heating member for evaporating a liquid resin material by heating; a holder for holding a substrate, upon which the evaporated resin material condenses, at a predetermined position; a vacuum tank housing the heating member, the substrate, and the holder; a primary tank portion including a pressure tank and a resin material cup disposed in the pressure tank and storing the liquid resin material; a supply portion including a supply tank storing the liquid resin material temporarily, and a piston disposed in the supply tank and displaced in correspondence with a volume of the liquid resin material in the supply tank; a primary side supply pipe for sending the liquid resin material from the resin material cup to the supply tank; and an evaporation side supply pipe for sending the liquid resin material from the supply tank to the heating member, wherein the liquid resin material is quantified by a stroke of the piston, and the quantified liquid resin material is sent to the heating member through the evaporation side supply pipe.

Furthermore, a second apparatus for producing a resin thin film of the present invention includes: a heating member for evaporating a liquid resin material by heating; a holder for holding a substrate, upon which the evaporated resin material condenses, at a predetermined position; a vacuum tank housing the heating member, the substrate, and the holder; a primary tank portion including a pressure tank and a resin material cup disposed in the pressure tank and storing the liquid resin material; a supply pipe for supplying the liquid resin material stored in the resin material cup to the heating member; and a flowmeter for measuring a flow amount of the liquid resin material flowing in the supply pipe, wherein a supply of the liquid resin material by the supply pipe is suspended when the flow amount of the liquid resin material obtained by the flowmeter reaches a predetermined value.

These and other advantages of the present invention will become apparent to those skilled in the art upon reading and understanding the following detailed description with reference to the accompanying figures.

### Brief Description of Drawings

FIG. 1 is a schematic cross-sectional view showing an example of an apparatus for producing a resin thin film for performing a method for producing a resin thin film according to Embodiment 1 of the present invention.

FIG. 2 shows a detailed configuration of a primary tank portion in the apparatus for producing a resin thin film according to Embodiment 1 of the present invention.

FIG. 3 shows a detailed configuration of a supply portion in the apparatus for producing a resin thin film according to Embodiment 1 of the present invention.

FIG. 4 shows another exemplary configuration of the supply portion in the apparatus for producing a resin thin film according to Embodiment 1 of the present invention.

FIG. 5 shows still another exemplary configuration of the supply portion in the apparatus for producing a resin thin film according to Embodiment 1 of the present invention.

FIG. 6 shows a detailed configuration of an evaporating portion in the apparatus for producing a resin thin film according to Embodiment 1 of the present invention.

FIG. 7 is a cross-sectional view showing a detailed configuration of a resin nozzle portion in the apparatus for producing a resin thin film according to Embodiment 1 of the present invention.

FIG. 8 is a cross-sectional view showing a vacuum tank and an internal configuration thereof in the apparatus for producing a resin thin film according to Embodiment 1 of the present invention.

FIG. 9 is a schematic cross-sectional view showing one embodiment of an apparatus for producing a layered product composed of a resin thin film and a metal thin film, obtained by combining an apparatus for producing a resin thin film of the present invention with an apparatus for forming a metal thin film.

FIGS. 10A and 10B respectively are cross-sectional views showing embodiments of a capacitor obtained by the method for producing a resin thin film of the present invention.

FIGS. 11A to 11D are cross-sectional views showing an example of the method for producing a capacitor by the method for producing a resin thin film of the present invention in the order of processes.

FIG. 12 is a cross-sectional view showing an embodiment of a sealing film for an organic EL formed by the method for producing a resin thin film of the present invention.

### Best Mode for Carrying Out the Invention

According to the above-mentioned first production method and first production apparatus, a resin material is quantified in a supply portion, and thereafter is supplied to a heating member. Therefore, a resin thin film with a desired thickness can be formed with good reproducibility, and a resin thin film of stable quality can be produced.

Furthermore, according to the above-mentioned second production method and second production apparatus, a resin material in a predetermined amount measured by a flowmeter can be supplied to a heating member. Therefore, a resin thin film with a desired thickness can be formed with good reproducibility in a simple configuration, and a resin thin film of stable quality can be produced at low cost.

Hereinafter, a method and apparatus for producing a resin thin film of the present invention will be described by way of embodiments with reference to the drawings.

### Embodiment 1

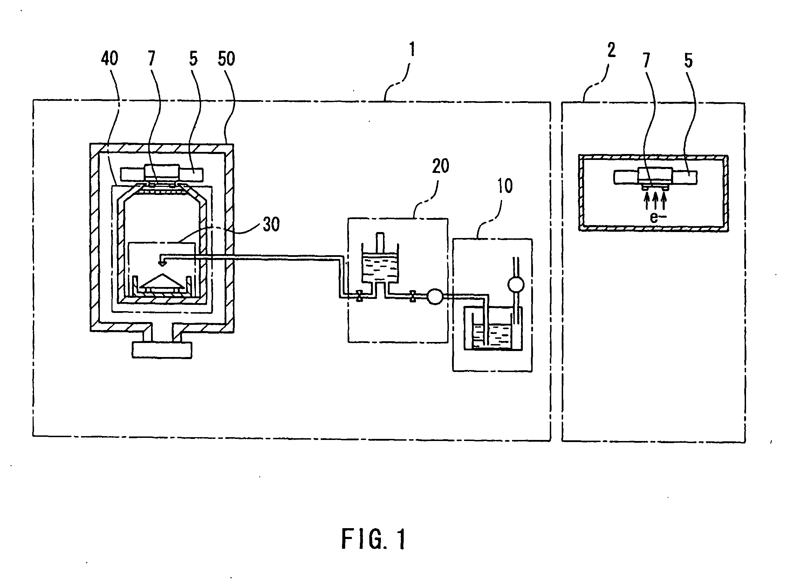

FIG. 1 is a cross-sectional view showing one embodiment of a method and apparatus for producing a resin thin film of the present invention.

An alternate long and short dash line 1 represents a resin thin film forming portion, and an alternate long and short dash line 2 represents a curing portion for curing a resin thin film formed in the resin thin film forming portion 1. In the resin thin film forming portion 1, a resin thin film is formed by vacuum film-formation on a substrate 7 attached to a substrate holder 5. Thereafter, the substrate holder 5 is transported to the curing portion 2, and the resin thin film on the substrate 7 is cured.

First, the resin thin film forming portion 1 will be described.

The resin thin film forming portion 1 is composed of a primary tank portion 10, a supply portion 20, an evaporating portion 30, a resin nozzle portion 40, and a vacuum tank 50. The primary tank portion 10 stores a previously prepared liquid resin material, and sends the resin material to the supply portion 20 under pressure. The supply portion 20 supplies a predetermined amount of the resin material to the evaporating portion 30. In the evaporating portion 30, the liquid resin material is dropped onto a heating plate and is evaporated by heating. The resin nozzle portion 40 guides the vapor of the resin material generated in the evaporating portion 30 set in the resin nozzle portion 40 to the surface of the substrate 7 and allows the vapor to adhere thereto. The substrate 7 and the resin nozzle portion 40 are set in the vacuum tank 50 held at a predetermined degree of vacuum.

Next, the above-mentioned respective portions constituting the resin thin film forming portion 1 will be described successively.

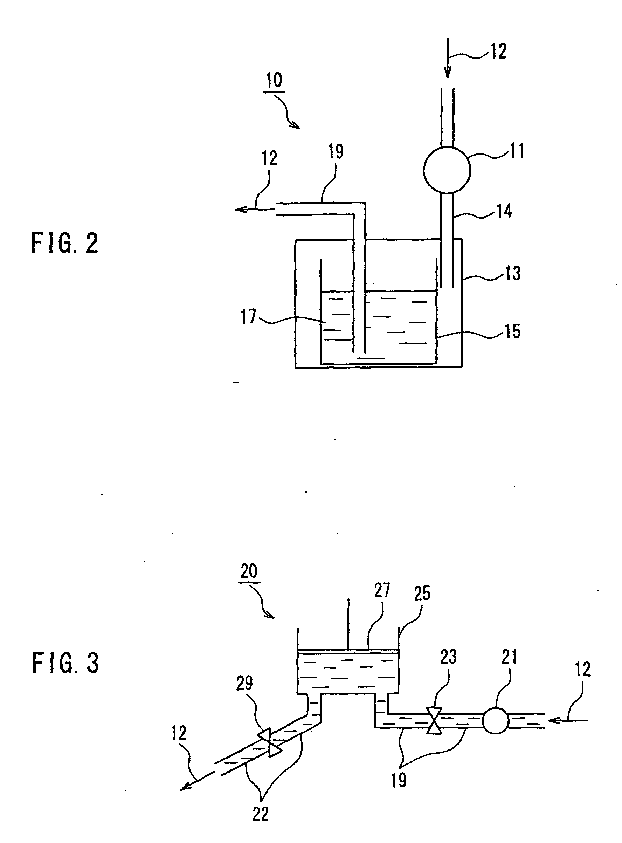

FIG. 2 shows a detail of an example of the primary tank portion 10 in FIG. 1. A resin material cup 15 storing a liquid resin material 17 whose liquid amount is adjusted previously is set in a sealed pressure tank 13. A pressure pipe 14 is connected to the pressure tank 13, and a pressure gas 12 is supplied to the pressure tank 13 under pressure through the pressure pipe 14. A regulator 11 is set in the pressure pipe 14, and the pressure of the pressure gas in the pressure tank 13 can be controlled to a desired value by using the regulator 11. By pressurizing the inside of the pressure tank 13, the resin material 17 in the resin material cup 15 is sent to the supply portion 20 under pressure through a primary side supply pipe 19.

As the pressure gas 12, it is preferable to use inert gas for the following reason. In the case of using active gas (e.g., oxygen), the resin material 17 is oxidized, which makes it difficult to form a resin thin film having the intended characteristics. As the inert gas, inexpensive nitrogen, or helium or argon, having no reactivity with the resin material 17 can be used.

Furthermore, in order to send a constant amount of the resin material 17 to the supply portion 20 under pressure, it is preferable to control the pressure in the pressure tank 13 with precision. For this purpose, it is preferable to use a precision regulator having, as pressure control precision, an error precision of about ±2% or less with respect to a designated value, instead of using a regulator of a normal grade having an error precision of about ±10% or less.

Next, an example of the supply portion 20 in FIG. 1 will be described with reference to FIG. 3.

The resin material sent from the primary tank portion 10 passes through the primary side supply pipe 19, is quantified by a flowmeter 21, has its supply amount controlled by a primary side valve 23, and is guided to a supply tank 25. A supply amount variable piston 27 is attached to the supply tank 25. The supply amount variable piston 27 can be moved upward/downward freely in accordance with the amount of the resin material in the supply tank 25, and the amount of the resin material to be stored in the supply tank 25 can be varied by adjusting the stroke of the supply amount variable piston 27. The resin material from the supply tank 25 passes through an evaporation side supply pipe 22 and an evaporation side valve 29, and is sent to the evaporating portion 30.

In the present embodiment, the resin material required for forming one resin thin film on the substrate 7 transported to the vacuum tank 50 intermittently is quantified in the supply portion 20 and supplied to the evaporating portion 30. By quantifying the resin material required for forming one resin thin film in the supply portion 20 at each time, the evaporation amount of the resin material in the evaporating portion 30 is made constant. As a result, a resin thin film having a desired thickness can be formed. The thickness of the resin thin film can be varied merely by changing the stroke of the supply amount variable piston 27.

Quantification of the resin material in the supply portion 20 includes filling the supply tank 25 with a predetermined amount of resin material and supplying the resin material filling the supply tank 25 to the evaporating portion 30.

The supply tank 25 may be filled with a resin material as follows.

First, the primary side valve 23 is closed, and the evaporation side valve 29 is opened. Since the evaporation side supply pipe 22 is connected to the vacuum tank 50, a vacuum is produced in the supply tank 25. The reason for initially producing a vacuum in the supply tank 25 is as follows. Unless a vacuum is produced in the supply tank 25, residual gas in the supply tank 25 remains in the supply tank 25 as bubbles, and the bubbles of the residual gas are discharged while the resin is supplied to the evaporating portion 30. As a result, the resin material cannot be quantified accurately.

Then, the evaporation side valve 29 is closed, and the primary side valve 23 is opened. The inside of the supply tank 25 is kept under vacuum, while the inside of the pressure tank 13 of the primary tank portion 10 is pressurized. Therefore, the resin material is sent from the primary tank portion 10 to the supply tank 25 under pressure through the primary side supply pipe 19. As a result, the supply amount variable piston 27 is moved to top dead center, whereby the supply tank 25 is filled with a predetermined amount of resin material, Herein, the stroke of the supply amount variable piston 27 is set appropriately in accordance with the thickness of the resin thin film to be formed on the substrate 7.

Next, the resin material filling the supply tank 25 is sent to the evaporating portion 30 as follows. After the primary side valve 23 is closed, the evaporation side valve 29 is opened. Then, due to the difference between the pressure of the resin material when it is sent to the supply tank 25 under pressure and the pressure in the vacuum tank 50, the resin material is discharged to the evaporating portion 30 through the evaporation side supply pipe 22. Since the primary side valve 23 is closed when the resin is discharged, even if the evaporation side valve 29 is opened, the resin material in the pressure tank 13 is not supplied to the supply tank 25. Thus, only the resin material previously filling the supply tank 25 can be supplied to the evaporating portion 30. As a result, the evaporation amount of the resin material in the evaporating portion 30 becomes constant. This makes it easy to control the thickness of the resin thin film to be formed, and satisfactory reproducibility of film thickness is possible.

The flow velocity of the resin material sent from the supply tank 25 to the evaporating portion 30 is determined by the pressure in the supply tank 25 and the inner diameter of the evaporation side supply pipe 22 connecting the supply tank 25 to the evaporating portion 30. As the inner diameter of the evaporation side supply pipe 22 is smaller, the flow velocity becomes smaller due to the viscosity of the resin material. In general, there is an upper limit to the evaporation ability (amount of the resin material that can be evaporated per unit time) of the evaporating portion 30 with respect to the resin material. Therefore, in the case where it is required to adjust the flow velocity of the resin material in accordance with the evaporation ability, the inner diameter of the evaporation side supply pipe 22 may need to be adjusted.

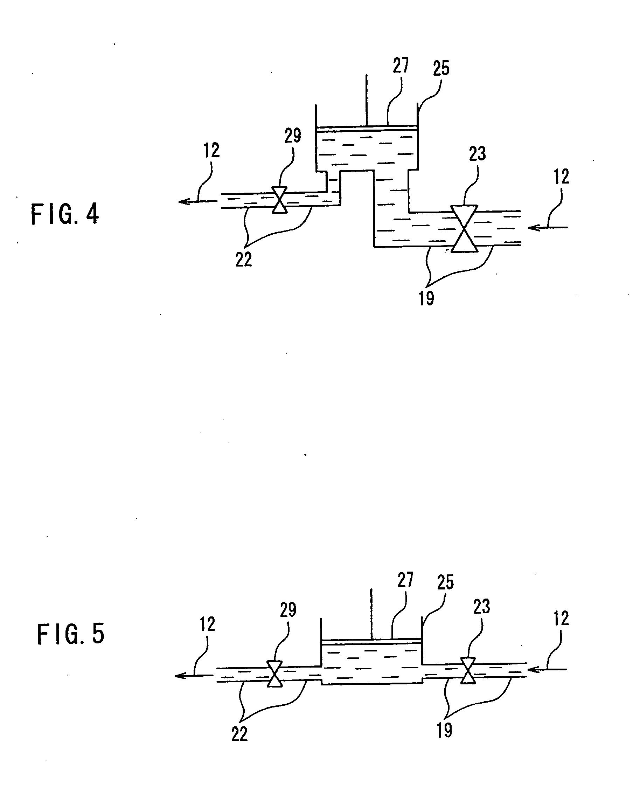

On the other hand, it is preferable that the inner diameter of the primary side supply pipe 19 for sending the resin material from the resin material cup 15 of the primary tank portion 10 to the supply tank 25 under pressure is determined in terms of a different point of view from that in the case of the above-mentioned evaporation side supply pipe 22. In the case where the inner diameter of the primary side supply pipe 19 is set as small as that of the evaporation side supply pipe 22, a pressure loss is caused due to the viscosity of the resin material. Therefore, the filling pressure of the resin material in the supply tank 25 becomes smaller than the pressure force of the pressure tank 13. Consequently, the difference between the filling pressure of the resin material in the supply tank 25 and the pressure in the vacuum tank 50 becomes small, which may cause a problem in supply of the resin material. The pressure loss in the primary side supply pipe 19 is decreased as the inner diameter of the pipe is increased, and is proportional to the length of the pipe. Thus, as shown in FIG. 4, it is preferable that the inner diameter of the primary side supply pipe 19 is set to be larger than that of the evaporation side supply pipe 22 so as to decrease the pressure loss caused in the primary side supply pipe 19. This prevents the supply of the resin material from the supply tank 25 to the evaporating portion 30 from being difficult due to the insufficient difference in pressure between the supply tank 25 and the vacuum tank 50, and prevents a part of the resin material from remaining in the supply tank 25, whereby the supply amount of the resin material becomes stable.

The primary side supply pipe 19 and the evaporation side supply pipe 22 desirably are attached to the bottom surface of the supply tank 25 as shown in FIG. 3, instead of the side surfaces of the supply tank 25 as shown in FIG. 5. When the primary side supply pipe 19 is attached to the side surface of the supply tank 25 as shown in FIG. 5, in the case where the supply amount variable piston 27 is in the vicinity of bottom dead center, the opening of the primary side supply pipe 19 is closed with the piston 27, which may cause a problem in sending the resin material to the supply tank 25 under pressure. Furthermore, when the evaporation side supply pipe 22 is attached to the side surface of the supply tank 25 as shown in FIG. 5, the resin material stored in a portion below the opening of the evaporation side supply pipe 22 cannot be discharged, and the resin supply amount does not become stable.

In the above description, the supply amount variable piston 27 is moved upward/downward freely in accordance with the amount of the resin material in the supply tank 25. However, the resin material may be sent to the evaporating portion 30 while the descending speed of the supply amount variable piston 27 is controlled. When this method is used, the flow velocity of the resin material to the evaporating portion 30 can be adjusted. There is an upper limit to the evaporation ability of the resin material depending upon the configuration of the evaporating portion 30. Therefore, when the flow velocity of the resin material is too high, the amount of resin that cannot be evaporated completely in the evaporating portion 30 is increased. In such a case, regardless of the quantification of the supply amount in the supply tank 25, a resin thin film with a desired thickness cannot be formed. By adjusting the descending speed of the supply amount variable piston 27 so as to supply the resin material at a flow velocity in accordance with the evaporation ability of the evaporating portion 30, the resin material can be evaporated efficiently, and the film thickness can be stabilized. As a procedure of adjusting the descending speed of the supply amount variable piston 27, there may be used methods such as those for connecting the supply amount variable piston 27 to a drive shaft of a direct-acting motor that moves in a straight line and those for connecting the supply amount variable piston 27 to an air cylinder-piston shaft so as to drive the supply amount variable piston 27 pneumatically with compressed air, in addition to a manual method.

In order to further enhance the quantification precision of the resin material, it is preferable that the flowmeter 21 is set in the primary side supply pipe 19, as shown in FIG. 3. It is possible that the resin material is quantified only by the stroke of the supply amount variable piston 27 without providing the flowmeter 21. However, by using the flowmeter 21 in addition to the supply amount variable piston 27 and closing the primary side valve 23 at a time when the flow amount (accumulated flow amount) of the resin material passing through the primary side supply pipe 19 reaches a predetermined value, quantification with higher precision is made possible.

Furthermore, it also is possible that the primary side supply pipe 19 is connected directly to the evaporation side supply pipe 22 without providing the primary side valve 23 and the supply tank 25, and the resin material is quantified only by the evaporation side valve 29 and the flowmeter 21 for the resin to be supplied. In this case, first, the evaporation side valve 29 is closed, and the inside of the pressure tank 13 is increased. Thereafter, when the evaporation side valve 29 is opened, the resin material is sent from the pressure tank 13 to the evaporating portion 30 under pressure. The flow amount of the resin material at this time is measured by the flowmeter 21, and the evaporation side valve 29 is closed at a time when the accumulated flow amount reaches a predetermined value, whereby a predetermined amount of the resin material can be supplied to the evaporating portion 30. This configuration is slightly inferior in terms of the stability of the supply amount, compared with that shown in FIG. 3 controlling the supply amount physically by the stroke of the supply amount variable piston 27. However, this simplifies the configuration of the supply portion 20, and facilitates its maintenance management. Thus, in the case where a high precision is not required for quantification of the resin material, such a method also can be adopted.

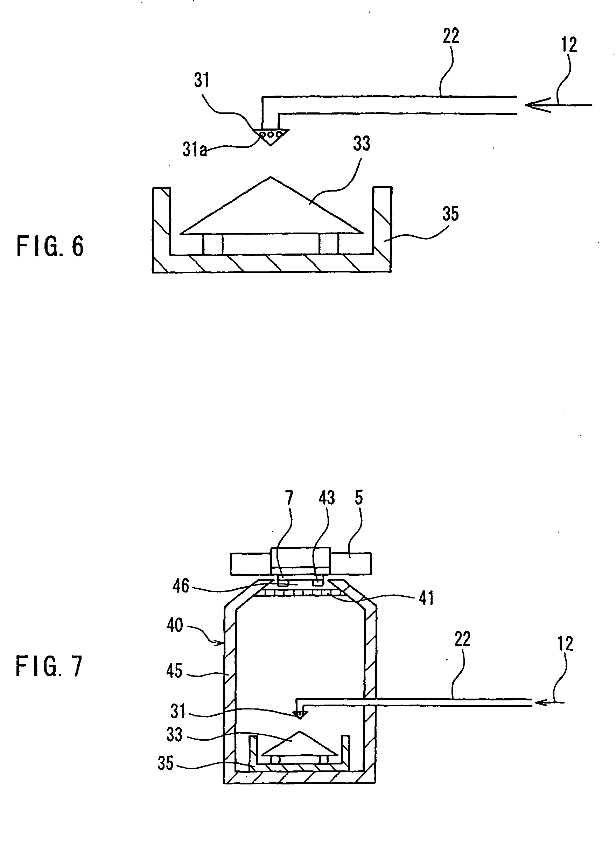

Next, an example of the evaporating portion 30 in FIG. 1 will be described with reference to FIG. 6.

The resin material 12 sent from the supply portion 20 via the evaporation side supply pipe 22 is dropped onto a heating plate 33 through holes 31a provided at a discharge nozzle 31. The heating plate 33 may have a circular conical surface or a polygonal conical surface, and is placed with an apex of the conical surface placed upward. The heating plate 33 is heated to a predetermined temperature by a heating device (heater) provided inside the conical surface or on the lower surface thereof. The resin material dropped in the vicinity of the apex of the heating plate 33 is heated while flowing on the heating plate 33. The resin material is heated while being spread thinly on the heating plate 33 by flowing, and is evaporated when it reaches an evaporation temperature. The resin material that has not been evaporated remains on a cup 35, whereby evaporation is completed.

In the case where the heating plate 33 has a polygonal conical surface, the resin material is spread only in the direction of the generating line. In the case where the heating plate 33 has a circular conical surface, the resin material is spread in the direction perpendicular to the generating line as well as in the direction of the generating line. Therefore, when the heating plate 33 has a circular conical surface, the surface area of the resin material is likely to be enlarged, and the efficiency at which the resin material is heated/evaporated is increased effectively, whereby an evaporation efficiency is enhanced. In other words, the amount of the resin material collected in the cup 35 without being evaporated is decreased, and a resin thin film having a desired thickness can be formed.

The discharge nozzle 31 may have a plurality of holes 31a through which the resin material is dropped. The discharge nozzle 31 of the present embodiment may have a circular conical shape or a polygonal conical shape with an apex placed downward, and a plurality of holes 31a are formed on an inclined surface. In the case where the resin material is dropped directly onto the heating plate 33 from the opening of the evaporation side supply pipe 22 without using the discharge nozzle 31, unless the resin material is dropped at an apex position of the conical surface of the heating plate 33, the resin material tends to flow in a partial narrow region of the heating plate 33. Therefore, the resin material cannot be spread thinly in a large area, and the evaporation efficiency of the resin material is decreased.

It also may be possible to supply the resin material to the heating plate 33 in an atomized form, instead of supplying the resin material in a liquid form to the heating plate 33 as liquid droplets by using the above-mentioned discharge nozzle 31. When the resin material is supplied in an atomized form, the adhesion area of the resin material on the heating plate 33 is enlarged, and the supply amount with the passage of time is stabilized, so that the variation in thickness of the resin thin film to be formed is decreased. There is no particular limit to a method for supplying the resin material in an atomized form. The method may be selected appropriately depending upon the kind of the resin material to be used. For example, atomization by injection supply, gas mixture and the like can be used preferably. According to these atomization methods, while the mechanical or thermal stress on the resin material is decreased, the resin material can be atomized by a relatively easy method.

It is preferable that the evaporation side supply pipe 22 is cooled. The heating plate 33 is heated (furthermore, as described later, a nozzle body 45 preferably is heated), and the evaporation side supply pipe 22 and the discharge nozzle 31 are heated by radiant heat from the heating plate 33 and the nozzle body 45. By cooling the evaporation side supply pipe 22 to decrease the temperature of the resin material, the resin material can be prevented from being thermally cured in the evaporation side supply pipe 22 and the discharge nozzle 31. For the same reason, it is preferable that the discharge nozzle 31 is cooled. There is no particular limit to a cooling method; however, a water-cooling method is preferable since it is easy and efficient.

When the thickness of the resin thin film to be formed on the substrate 7 is made constant, it is required to change the amount of resin to be evaporated in proportion to the area of the substrate 7. The discharge nozzle 31 and the heating plate 33 shown in FIG. 6 preferably are applied to the case where the area of the substrate is relatively small. On the other hand, in the case where the area of the substrate is large, it is preferable that, as disclosed in JP 11(1999)-209870 A, a plurality of holes 31a are disposed over a wide range, and an evaporation area is maximized using the heating plate having a large surface area, whereby the evaporation efficiency is enhanced. Even in such a case, stable evaporation is possible by using the primary tank portion 10 and the supply portion 20 together.

Next, an example of the resin nozzle portion 40 in FIG. 1 will be described with reference to FIG. 7.

The resin nozzle portion 40 contains the evaporating portion 30 including the heating plate 33 and the cup 35, the nozzle body 45 having an opening 46 in an upper portion, and a porous member 41 disposed in the vicinity of the opening 46 of the nozzle body 45. The substrate 7 on which the resin thin film is to be formed is held by the substrate holder 5, and is set above the porous member 41 and in the vicinity of the opening 46 of the nozzle body 45.

The resin nozzle portion 40-is placed in the vacuum tank 50 (see FIG. 1). Therefore, the vapor of the resin evaporated on the heating plate 33 moves upward in the nozzle body 45 toward the substrate 7, passes through minute continuous pores in the porous member 41, adheres to the substrate 7 placed in the vicinity of the opening 46, and forms a resin thin film in a liquid form. A mask 43 is attached to the substrate 7, for preventing the resin thin film from being formed in an unnecessary portion on the substrate 7.

The porous member 41 prevents the resin material dropped from the discharge nozzle 31 from scattering as resin liquid droplets in a particle form to adhere to the substrate 7 due to the rapid increase in temperature when the resin material is heated on the heating plate 33. Furthermore, the porous member 41 makes the amount of the resin vapor discharged from the opening 46 of the nozzle body 45 uniform in a plane parallel to the surface of the substrate 7, thereby suppressing the in-plane variation in thickness of the resin thin film to be formed. The porous member 41 preferably is heated. In particular, it is preferable that the porous member 41 is heated to a temperature that is substantially equal to or higher than the evaporation temperature of the resin material. This prevents the resin vapor from condensing on the porous member 41, and also prevents the scattered resin liquid droplets from continuing to adhere to close the continuous pores of the porous member 41. As the material for the porous member 41, for example, metal can be used.

Furthermore, it is desirable that the mask 43 also is heated to a temperature equal to or higher than the evaporation temperature of the resin material. The reason for this is as follows: in the case where a resin thin film is formed while a plurality of substrates are exchanged, unless the mask 43 is heated, the resin material is deposited on the mask 43, and a mask precision is decreased.

The nozzle body 45 is provided so as to efficiently guide the vapor of the evaporated resin and allow it to adhere to the substrate 7. It is desirable that the nozzle body 45 also is heated to a temperature equal to or higher than the evaporation temperature of the resin material in the same way as in the porous member 41 and the mask 43. Because of this, the resin vapor is prevented from condensing on an inner surface of the nozzle body 45, and the thickness of the resin thin film is stabilized. Furthermore, the gap between the opening 46 of the nozzle body 45 and the substrate 7 or the substrate holder 5 preferably is 10 mm or less so as to enhance the adhesion efficiency of the resin vapor to the substrate 7. As the gap is larger, the resin vapor is more likely to be exhausted through the gap. Therefore, the efficiency of use of the resin material is decreased, and the thickness of the resin thin film becomes unstable. As described above, according to the present invention, a resin material exactly quantified in the supply portion 20 is evaporated on the heating plate 33 and allowed to adhere to the substrate 7, whereby it is attempted to stabilize the thickness of the resin thin film to be formed. Furthermore, by minimizing the above-mentioned gap, the amount of the resin to be exhausted is reduced, and a resin thin film having a thickness in accordance with the supply amount can be obtained.

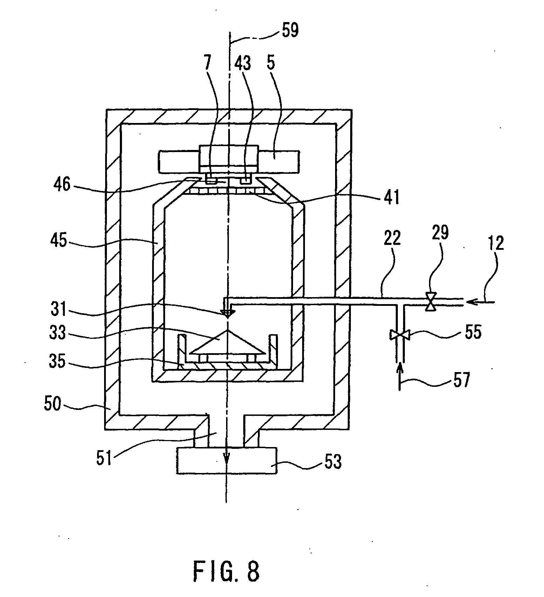

Next, an example of the vacuum tank 50 shown in FIG. 1 will be described with reference to FIG. 8.

The substrate 7 and the nozzle body 45 are placed in the vacuum tank 50, and the inside of the vacuum tank 50 is maintained at a predetermined degree of vacuum by a vacuum pump 53. The vacuum tank 50 has an open/close door (not shown) for loading/unloading the substrate 7 on which the resin thin film is to be formed and the substrate holder 5 holding the substrate 7, and for forming a partition with respect to an adjacent chamber. As the open/close door, a gate valve or the like is suitable that is used generally for partitioning adjacent vacuum tanks of a vacuum apparatus having a plurality of vacuum tanks.

As shown in FIG. 8, it is preferable that a suction port 51 leading to the vacuum pump 53 in the vacuum tank 50, the opening 46 of the nozzle body 45, and the substrate 7 are placed substantially in a straight line represented by an alternate long and short dash line 59. Furthermore, it is preferable that the evaporating portion 30 and the resin nozzle portion 40 are substantially symmetrical with respect to the alternate long and short dash line 59. Because of this, the flow of the resin vapor becomes symmetrical with respect to the alternate long and short dash line 59, so that the variation in thickness of the resin thin film to be formed on the substrate 7 can be reduced.

Furthermore, in order to prevent the resin vapor leaking out of the nozzle body 45 from the gap between the opening 46 of the nozzle body 45 and the substrate 7 or the substrate holder 5 from adhering to the inner wall of the vacuum tank 50 by the time when the resin vapor is exhausted by the vacuum pump 53, it is desirable that the inner wall of the vacuum tank 50 is heated to a temperature that is substantially equal to or higher than the evaporation temperature of the resin material.

Furthermore, as shown in FIG. 8, it is preferable that the evaporation side supply pipe 22 is branched so as to allow the introduction of gas, and at a time when formation of the resin thin film is completed, the evaporation side valve 29 is closed and a gas introducing valve 55 is opened to introduce gas 57 into the nozzle body 45. When the resin material is evaporated, the vapor of the resin material continues to be present in the nozzle body 45 for a certain period of time. Therefore, during such a period, the substrate cannot be transported to the subsequent process, which may decrease productivity. By introducing the gas into the nozzle body 45 so as to obtain a pressure equal to or higher than a resin vapor pressure, the resin material that has not been evaporated on the heating plate 33 can be prevented from being newly evaporated. As a result, by suppressing the generation of new resin vapor, a time for transporting the substrate 7 from the vacuum tank 50 to another treatment unit after formation of the resin thin film can be shortened, which enhances productivity. As the gas 57, it is preferable to use inert gas. For example, inexpensive nitrogen, or helium or argon, that has no reactivity can be used.

According to the present invention, there is no particular limit to the material for the resin thin film, as long as it can condense to form a thin film on a substrate after being evaporated by heating as described. Although the material can be selected appropriately in accordance with the use of the resin thin film, a reactive monomer material preferably is used. For example, in the case where the resin thin film is used for an electronic component material, those which contain acrylate resin or vinyl resin as a main component are preferable. More specifically, a polyfunctional (meth)acrylate monomer, a polyfunctional vinyl monomer, and a polyfunctional vinyl ether monomer are preferable. Among them, cyclopentadiene dimethanol diacrylate, a cyclohexane dimethanol divinyl ether monomer, divinylbiphenyl, etc., or monomers whose hydrocarbon groups are substituted are preferable. This is because the resin thin film formed of these materials is excellent in electrical characteristics, heat resistance, stability, and the like.

It is required that the above-mentioned resin thin film material is a liquid so as to realize the above-mentioned resin supply and dropping. In the case where the melting point of the resin thin film material is a solid at a temperature equal to or higher than room temperature, it is required to liquefy the resin thin film material by heating the primary tank portion 10, the supply portion 20, and the evaporation side supply pipe 22 to a temperature equal to or higher than the melting point. Furthermore, it also is required to keep the temperature of the substrate 7 on which a resin thin film is to be formed at a temperature equal to or higher than the melting point of the resin thin film material. The reason for this is as follows: when the substrate 7 is at a temperature lower than the melting point, the resin thin film material adhering to the substrate 7 is solidified, and cannot be polymerized even by irradiation with an electron beam later.

The substrate 7, on which a liquid film of a resin material is formed by the above-mentioned method, is transported to the curing portion 2 shown in FIG. 1, and the resin material is cured to form a resin thin film. The resin material can be cured by electron beam irradiation, UV (ultraviolet) irradiation, plasma irradiation, or the like.

The extent of curing treatment may be changed appropriately depending upon the use and required characteristics of the resin thin film to be produced. For example, if a resin thin film for an electronic component such as a capacitor is produced, it is preferable that the resin material is cured until the curing degree reaches 50 to 95%, more preferably 50 to 75%. When the curing degree is smaller than the above ranges, during the process of pressing the resin thin film obtained by the method of the present invention or mounting the resin thin film on a circuit substrate as an electronic component, the resin thin film is deformed easily by application of an external force or the like. Furthermore, a metal thin film formed as an electrode on a resin thin film by vapor deposition or the like may be ruptured or short-circuited. On the other hand, when the curing degree is larger than the above ranges, the resin thin film may be cracked due to the shrinkage by curing. The curing degree as used herein is defined as a value obtained by determining the ratio of the absorbance of the C=O groups and the C=C groups (1600 cm⁻¹) with an infrared spectrophotometer, determining the ratio of each monomer and the cured product, and subtracting the reduced absorption ratio from 1.

### Embodiment 2

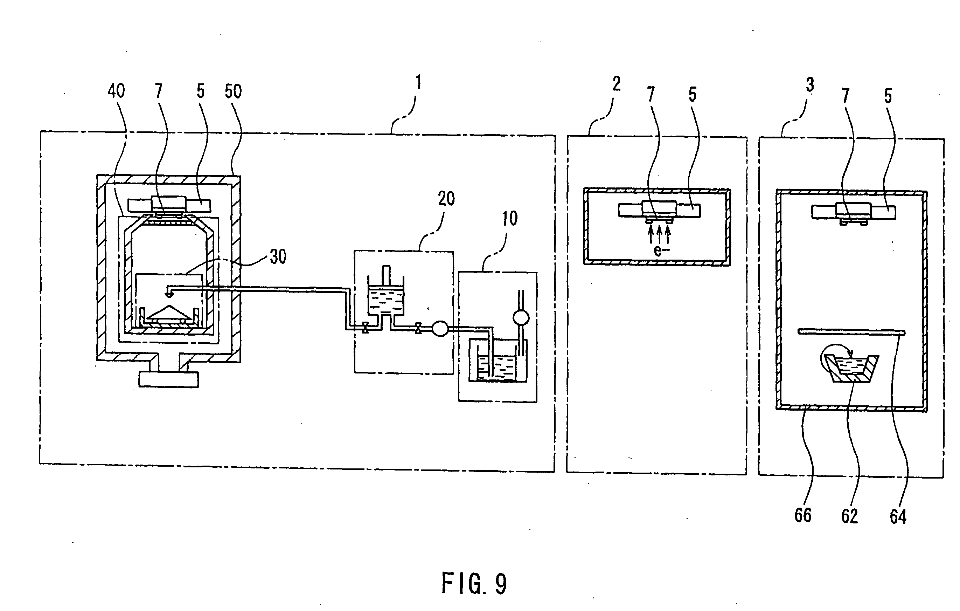

An example of producing an electronic component using a resin thin film obtained by the present invention will be described with reference to FIG. 9.

FIG. 9 shows a schematic configuration of a production apparatus for stacking a resin thin film and a metal thin film on the substrate 7. The resin thin film is formed by the same method as that described in Embodiment 1 using the resin thin film forming portion 1 and the curing portion 2. In FIG. 9, the resin thin film forming portion 1 and the curing portion 2 are the same as those described in Embodiment 1, and the detailed description thereof will be omitted here.

The substrate 7 held by the substrate holder 5 is transported to the vacuum tank 50 in the resin thin film forming portion 1, and a resin material is deposited by the method described in Embodiment 1 under the condition that the substrate 7 remains at rest. Thereafter, the substrate 7 is transported to the curing portion 2, and the resin material is cured to form a resin thin film. Next, the substrate 7 is transported to a metal thin film forming portion 3, and a metal thin film is formed on the resin thin film. Then, the substrate 7 is transported again to the resin thin film forming portion 1, if required. Thereinafter, the same process as described above may be repeated. Because of this, a layered product in which the resin thin films and the metal thin films are stacked alternately is formed on the substrate 7.

The metal thin film forming portion 3 includes an electron beam heating evaporation source 62, a movable shutter 64 disposed between the substrate 7 and the evaporation source 62, and a vacuum tank 66 housing the evaporation source 62 and the shutter 64, as shown in FIG. 9. The inside of the vacuum tank 66 is kept at a predetermined degree of vacuum by a vacuum pump (not shown).

As the method for forming a metal thin film, in addition to the electron beam heating vapor deposition shown in FIG. 9, a well-known vacuum thin film forming process, such as resistance heating vapor deposition, induction heating vapor deposition, sputtering and ion plating, or metal plating can be used.

A mask is used for forming each thin film so that the resin thin films and the metal thin films are formed only in a predetermined region. For example, in the case where the above-mentioned layered product is used as a capacitor, the upper and lower metal thin films sandwiching the resin thin film are formed by shifting the position of the mask so as to form opposed portions as a capacitor.

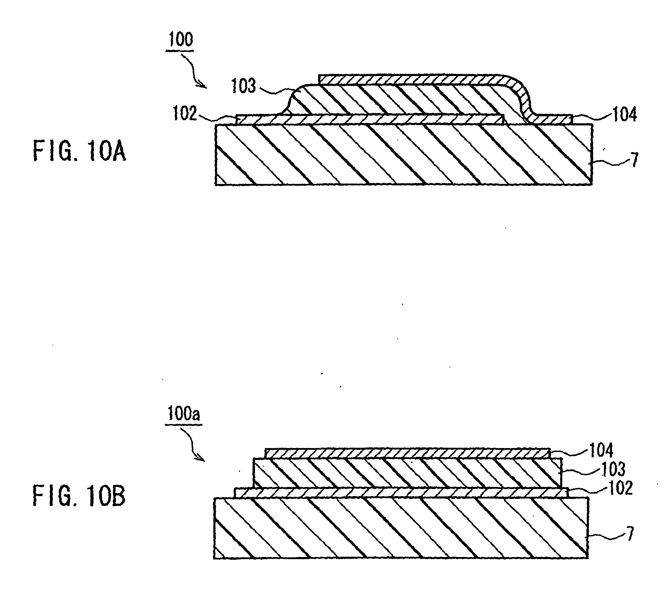

FIG. 10A shows a cross-sectional view of an example of a capacitor 100 of Embodiment 2. As another embodiment, a layered product configuration such as a capacitor 100a as shown in FIG. 10B may be used.

The capacitor 100 shown in FIG. 10A includes a substrate 7, a lower electrode film 102 formed on the substrate 7, a dielectric film 103 disposed mainly on the lower electrode film 102, and an upper electrode film 104 disposed mainly on the dielectric film 103. Herein, the dielectric film 103 is a resin thin film (which further may contain an additive) formed by the method described in Embodiment 1. Furthermore, the lower and upper electrode films 102 and 104 are metal thin films formed in the metal thin film forming portion 3 in FIG. 9.

Various materials can be used for the substrate 7 as a support. Specifically, for example, glass, or a polymer film made of polyethylene terephthalate (hereinafter, which may be referred to as "PET"), polyethylene naphthalate (PEN), polyphenylene sulfide (PPS), polyamide (PA), or polyimide (PI). There is no particular limit to the thickness of the substrate 7. In general, the thickness of the substrate 7 is in a range of about 1 µm to 75 µm in the case where the substrate 7 is made of a polymer film. The thickness of the substrate 7 is in a range of about 0.1 mm to 1 mm in the case where the substrate 7 is made of glass. In the case where the lower electrode film 102 also functions as a support, the substrate 7 is not required. Furthermore, after the lower electrode film 102, the dielectric film 103, and the upper electrode film 104 are formed, the substrate 7 may be removed. That is, the capacitor according to the present invention need not have a support.

As the lower electrode film 102 and the upper electrode film 104, a conductive film (e.g., a metal film) can be used. More specifically, a metal film mainly containing aluminum, zinc, copper, and the like can be used. There is no particular limit to the thickness of the electrode film. For example, a film having a thickness in a range of 10 nm to 150 nm, preferably in a range of 20 nm to 50 nm, can be used. The lower electrode film 102 and the upper electrode film 104 of the capacitor 100 are connected to an electric circuit, respectively. As a method for connecting to the electric circuit, for example, soldering, metal spraying, clamping, and the like can be used.

The dielectric film 103 is a resin thin film obtained by forming a thin film containing at least one kind of resin monomer, and polymerizing the thin film. The thin film may contain one kind of resin monomer or a plurality of kinds of resin monomers.

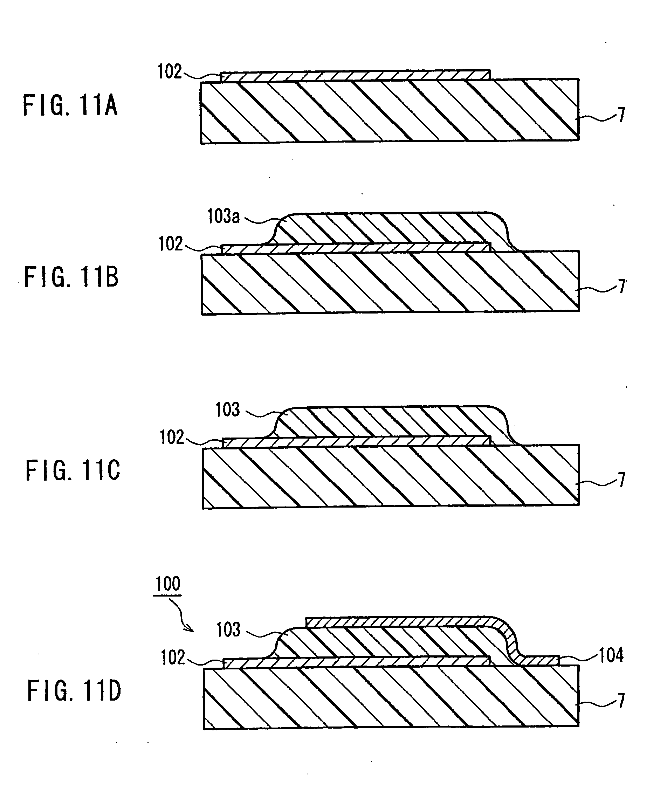

Next, a method for producing the capacitor 100 will be described. FIG. 11 shows an exemplary production method in the order of processes.

First, as shown in FIG. 11A, the lower electrode film 102 is formed on the substrate 7. The lower electrode film 102 is formed in the metal thin film forming portion 3 shown in FIG. 9. The lower electrode film 102 can be formed by vacuum vapor deposition such as electron beam heating vapor deposition, resistance heating vapor deposition, and inductance heating vapor deposition, ion plating, sputtering, metal plating, or the like. In order to form the lower electrode film 102 in a predetermined shape, a metal mask can be used.

Next, as shown in FIG. 11B, a thin film 103a containing a resin monomer is formed on the lower electrode film 102. The thin film 103a becomes a dielectric film 103 by polymerization. The thin film 103a can be formed by depositing a resin monomer, using the resin thin film forming portion 1 described in Embodiment 1. In order to form the thin film 103a in a predetermined shape, a metal mask should be used.

Next, by polymerizing the resin monomer of the thin film 103a, a dielectric film 103 is formed, as shown in FIG. 11C. Polymerization (curing) can be effected by irradiating the thin film 103a, for example, with UV light or an electron beam by using the curing portion 2 described in Embodiment 1.

Next, as shown in FIG. 11D, the upper electrode film 104 is formed by the same method as that of the lower electrode film 102. At this time, the metal mask used for forming the lower electrode film 102 can be used by slightly shifting the setting position.

Thus, the capacitor 100 can be produced. The capacitor 100a also can be produced by the same production method.

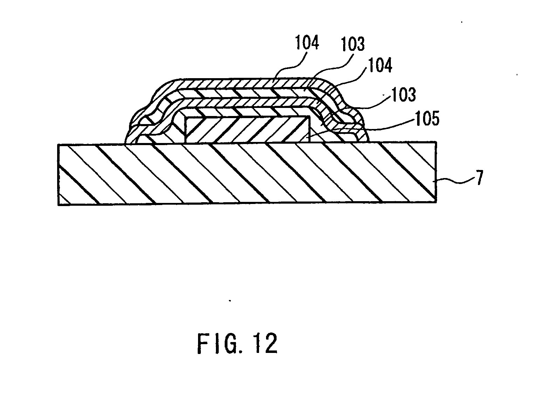

By using the method described in the present embodiment, a sealing film of an organic EL device and an IC device can be formed similarly. FIG. 12 is a cross-sectional view showing an exemplary configuration thereof. A resin thin film 103 is formed so as to cover an organic EL device 105 formed on the substrate 7, and an inorganic thin film 104 is formed on the resin thin film 103. Furthermore, another resin thin film 103 and another inorganic thin film 104 are formed similarly. The inorganic thin film may be a metal thin film, or may be an inorganic thin film such as a metal oxide film and a metal nitride film. The type of the inorganic thin film is selected depending upon the required sealing performance. Either type can be formed by using the metal thin film forming portion 3 shown in FIG. 9.

The positions for forming the resin thin film 103 and the inorganic thin film 104 with respect to the device 105 are adjusted by the setting position of a metal mask. At this time, the respective thin films 103 and 104 are formed so that the inorganic thin film 104 covers the farther outside in a plane direction of the substrate 7, compared with the resin thin film 103. Because of this, it is possible to prevent gas from entering from an end portion of the thin film.

### Examples

### Example 1

A capacitor was produced by using the apparatus shown in FIG. 9.

The produced capacitor is composed of a layered product including a protection layer (in which resin thin films are stacked continuously), a device layer (in which resin thin films and metal thin films are stacked alternately), and a protection layer (in which resin thin films are stacked continuously) in this order.

The resin thin films were formed by using the resin thin film forming portion 1 and the curing portion 2.

The primary tank portion 10 was designed so as to have a configuration shown in FIG. 2. Nitrogen was used as the pressure gas 12, and the pressure in the pressure tank 13 was kept at 0.2 × 10⁶ Pa using a precision regulator (detection error precision: ±2% or less) 11.

The supply portion 20 was designed so as to have a configuration shown in FIG. 4. The maximum capacity of the supply tank 25 was 15 × 10⁻⁶ m³. The inner diameter of the primary side supply pipe 19 was set to be 9.5 mm (3/8 inches), and the inner diameter of the evaporation side supply pipe 22 was set to be 6.35 mm (1/4 inches). The primary side supply pipe 19 and the evaporation side supply pipe 22 were connected to the bottom surface of the supply tank 25. The flow velocity of the resin material passing through the evaporation side supply pipe 22 was adjusted manually by regulating the descending speed of the supply amount variable piston 27.

The evaporating portion 30 was designed so as to have a configuration shown in FIG. 6. The heating plate 33 having a circular conical surface with an inclined angle of 10° with respect to the horizontal direction was kept at 150°C. The discharge nozzle 31 had a circular conical shape with an apex placed downward, with the holes 31a formed on the circular conical surface at a predetermined interval.

The resin nozzle portion 40 was designed so as to have a configuration shown in FIG. 7. As the porous member 41, "Cellmet #3" (pore diameter: 1.3 mm) produced by Sumitomo Electric Industries, Ltd. was used. As the substrate 7, a silicon wafer was used. The outer peripheral surface of the substrate holder 5 was cooled to 10°C.

The vacuum tank 50 was designed so as to have a configuration shown in FIG. 8. The space in the vacuum tank 50 was kept at 0.01 Pa.

As the resin material, dicyclopentadiene dimethanol diacrylate was used.

First, only resin thin films were stacked continuously on the substrate 7 to form a protection layer of a capacitor. The stroke of the supply amount variable piston 27 was adjusted so that 5 × 10⁻⁶ m³ was measured. As described in Embodiment 1, the primary side valve 23 and the evaporation side valve 29 were operated, whereby the resin material supplied via the evaporation side supply pipe 22 was dropped in the vicinity of the apex of the circular conical surface of the heating plate 33 through the holes 31a provided in the discharge nozzle 31. The resin material was spread thinly while flowing on the heating plate 33, and was evaporated by heating during that process. The vapor of the resin material condensed on the surface of the substrate 7.

After evaporation of all the resin material supplied to the evaporating portion 30 was completed, the substrate 7 was transported to the curing portion 2, whereby the resin material was cured. The resin material was cured by an electron beam curing apparatus, and was polymerized until the curing degree reached 70%.

Thus, a resin thin film with a thickness of 0.3 µm (design value) was formed on the substrate 7.

The above-mentioned operation was repeated by moving the substrate 7, whereby a protection layer having a total thickness of 10 µm (design value), in which only resin thin films were stacked continuously, was formed on the substrate 7.

Then, a portion (device layer) for generating a capacitance as a capacitor, in which resin thin films and metal thin films were stacked alternately, was stacked on the protection layer. A resin thin film having a thickness of 0.15 µm (design value) was formed in the same way as in the case of the resin thin film in the above-mentioned protection layer, except that the stroke of the supply amount variable piston 27 was changed so that 2.5 × 10⁻⁶ m³ was measured and that the resin material was deposited via a mask having a shielding pattern of a plurality of bands with a width of 150 µm disposed in parallel with each other. Next, the substrate 7 was moved to the metal thin film forming portion 3, and a metal thin film having a thickness of 30 nm made of aluminum was formed by electron beam heating vapor deposition. This operation was repeated 10 times by moving the substrate 7, whereby resin thin films and metal thin films were stacked alternately. The setting position of the mask used for forming the resin thin films was moved by 1000 µm alternately in directions orthogonal to the longitudinal direction of the band-shaped shielding pattern for each film-formation of the resin thin film. Consequently, the device layer with a total thickness of 80 µm (design value) was formed.

Finally, only resin thin films were stacked continuously to form a protection layer having a thickness of 10 µm (design value). The formation method was the same as that in the case of the above-mentioned protection layer.

Thus, a layered product for a capacitor was obtained on the substrate 7.

### Example 2

A layered product for a capacitor was obtained on the substrate 7 in the same way as in Example 1, except that the attachment positions of the primary side supply pipe 19 and the evaporation side supply pipe 22 with respect to the supply tank 25 in the supply portion 20 were placed on the side surfaces of the supply tank 25, as shown in FIG. 5.

### Example 3

In the evaporating portion 30, a layered product for a capacitor was obtained on the substrate 7 in the same way as in Example 1, except that a resin material was dropped directly onto the heating plate 33 from a downstream end of the evaporation side supply pipe 22, without using the discharge nozzle 31.

Each layered product for a capacitor obtained in Examples 1 to 3 was separated from the substrate 7 and cut in liquid nitrogen. The cross-section thereof was observed with an electron microscope, and the thickness of each resin thin film in the device layer was measured. Then, an average value, a maximum value, and a minimum value of the measured thickness of the resin thin film were obtained. Table 1 shows the result.

**Table 1**

| | Film thickness (µm) | | |
|---|---|---|---|
| | Average | Maximum | Minimum |
| Example 1 | 0.15 | 0.16 | 0.14 |
| Example 2 | 0.14 | 0.16 | 0.08 |
| Example 3 | 0.13 | 0.16 | 0.07 |

As shown in Table 1, in Example 1, the average value of the film thickness was matched with the intended value (design value), and a variation range of film thickness also was small.

In Example 2, the average value of the film thickness was smaller than that in Example 1, and the variation range of film thickness was larger than that in Example 1. In particular, the minimum value was remarkably smaller than that in Example 1. The reason for this is considered as follows: when a resin material was quantified in the supply portion 20, the resin material remained in the supply tank 25, and the residual amount was changed for each quantification.

In Example 3, the film thickness was decreased gradually with an increase in the number of stacking of resin thin films. Therefore, the average value and the minimum value were both smaller than those in Example 1. The reason for this is considered as follows: the resin material flowed only in a particular narrow region without being spread largely on the heating plate 33, so that the temperature of that region of the heating plate 33 was decreased gradually, and the cured product of the thermally modified resin material was deposited gradually in the narrow region, whereby the evaporation efficiency of the resin material was decreased gradually.

### Example 4

A flattening layer and a protection layer were formed successively on the substrate 7 on which an organic EL device has been formed by using the apparatus shown in FIG. 9.

The flattening layer was formed by stacking resin thin films continuously. Furthermore, the protection layer was formed by stacking resin thin films and metal oxide thin films alternately. The protection layer protects the organic EL device from humidity and oxygen.

The resin thin films were formed by using the resin thin film forming portion 1 and the curing portion 2.

The primary tank portion 10 was designed so as to have a configuration as shown in FIG. 2. Nitrogen was used as the pressure gas 12, and the pressure in the pressure tank 13 was kept at 1.5 × 10⁶ Pa using a precision regulator (detection error precision: ±2%) 11.

The supply portion 20 was designed so as to have a configuration shown in FIG. 4. The maximum capacity of the supply tank 25 was 25 × 10⁻⁶ m³. The inner diameter of the primary side supply pipe 19 was set to be 9.5 mm (3/8 inches), and the inner diameter of the evaporation side supply pipe 22 was set to be 6.35 mm (1/4 inches). The primary side supply pipe 19 and the evaporation side supply pipe 22 were connected to the bottom surface of the supply tank 25. The flow velocity of the resin material passing through the evaporation side supply pipe 22 was adjusted manually by regulating the descending speed of the supply amount variable piston 27.

The evaporating portion 30 was designed so as to have a configuration shown in FIG. 6. The heating plate 33 having a circular conical surface with an inclined angle of 10° with respect to the horizontal direction was kept at 150°C. The discharge nozzle 31 had a circular conical shape with an apex placed downward, with the holes 31a formed on the circular conical surface at a predetermined interval.

The resin nozzle portion 40 was designed so as to have a configuration shown in FIG. 7. As the porous member 41, "Cellmet #3" (pore diameter: 1.3 mm) produced by Sumitomo Electric Industries, Ltd. was used. As the substrate 7, glass was used. The outer peripheral surface of the substrate holder 5 was cooled to 10°C.

The vacuum tank 50 was designed so as to have a configuration shown in FIG. 8. The space in the vacuum tank 50 was kept at 0.01 Pa.

As the resin material, dicyclopentadiene dimethanol diacrylate was used.

Only resin thin films were stacked continuously on the outer surface of the substrate 7 with an EL device previously formed thereon, thereby forming a flattening layer. The stroke of the supply amount variable piston 27 was adjusted so that 15 × 10⁻⁶ m³ was measured. As described in Embodiment 1, the primary side valve 23 and the evaporation side valve 29 were operated, and the resin material was dropped in the vicinity of the apex of the circular conical surface of the heating plate 33 through the holes 31a provided in the discharge nozzle 31 via the evaporation side supply pipe 22. The resin material was spread thinly while flowing on the heating plate 33, and was evaporated by heating during that process. The vapor of the resin material was liquefied to be deposited on the surface of the substrate 7.

After evaporation of all the resin material supplied to the evaporating portion 30 was completed, the substrate 7 was transported to the curing portion 2, whereby the resin material was cured. The resin material was cured by an electron beam curing apparatus, and the resin material was polymerized until the curing degree reached 70%.

Thus, a resin thin film with a thickness of 1 µm was formed on the substrate 7 so as to cover the EL device.

The above-mentioned operation was repeated by moving the substrate 7, whereby a flattening layer having a total thickness of 5 µm, in which only resin thin films were stacked continuously, was formed on the substrate 7.

Then, a protection layer, in which resin thin films and metal oxide thin films were stacked alternately, was stacked on the flattening layer. A resin thin film having a thickness of 1 µm was formed in the same way as in the case of the resin thin film in the flattening layer, except that the resin material was deposited via a mask so that the resin thin film was formed in a range larger by 1 mm in the outer direction from the film-formation portion of the organic EL device. Then, the substrate 7 was moved to the metal thin film forming portion 3, whereby a metal oxide thin film having a thickness of 50 nm made of aluminum oxide was formed by electron beam heating vapor deposition. At this time, a metal oxide thin film was formed in a range larger by 2 mm in the outer direction from the range in which the resin thin film was formed previously. This operation was repeated 10 times by moving the substrate 7, whereby resin thin films and metal oxide thin films were stacked alternately. Thus, a protection layer having a total thickness of 15.5 µm was formed.

The invention may be embodied in other forms without departing from the spirit or essential characteristics thereof. The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

## Claims

1. A method for producing a resin thin film, using an apparatus for producing a resin thin film comprising:
a heating member for evaporating a liquid resin material by heating;
a holder for holding a substrate, upon which the evaporated resin material condenses, at a predetermined position;
a vacuum tank housing the heating member, the substrate, and the holder;
a primary tank portion including a pressure tank and a resin material cup disposed in the pressure tank and storing the liquid resin material;
a supply portion including a supply tank storing the liquid resin material temporarily, and a piston disposed in the supply tank and displaced in correspondence with a volume of the liquid resin material in the supply tank;
a primary side supply pipe for sending the liquid resin material from the resin material cup to the supply tank;
a primary side valve provided in the primary side supply pipe;
an evaporation side supply pipe for sending the liquid resin material from the supply tank to the heating member; and
an evaporation side valve provided in the evaporation side supply pipe, the method comprising:
when the primary side valve is open and the evaporation side valve is closed, increasing a pressure in the pressure tank, thereby sending the liquid resin material in the resin material cup to the supply tank under pressure through the primary side supply pipe; and
closing the primary side valve, opening the evaporation side valve, and sending the liquid resin material in the supply tank to the heating member through the evaporation side supply pipe.

2. A method for producing a resin thin film according to claim 1, further comprising, before sending the liquid resin material in the resin material cup to the supply tank under pressure, closing the primary side valve and opening the evaporation side valve to produce a vacuum in the supply tank.

3. A method for producing a resin thin film according to claim 1, wherein an amount of the liquid resin material adhering to the substrate is varied by changing a stroke of the piston.

4. A method for producing a resin thin film according to claim 1, wherein after the piston reaches top dead center, the primary side valve is closed and the evaporation side valve is opened.

5. A method for producing a resin thin film according to claim 1, wherein, in sending the liquid resin material in the supply tank to the heating member, a displacement speed of the piston is controlled in accordance with evaporation ability of the heating member with respect to the liquid resin material.

6. A method for producing a resin thin film according to claim 1, wherein a flow amount of the liquid resin material passing through the primary side supply pipe is measured, and when the flow amount reaches a predetermined value, the primary side valve is closed.

7. A method for producing a resin thin film according to claim 1, wherein the apparatus for producing a resin thin film further comprises a resin nozzle having an opening, and
the resin nozzle is placed in the vacuum tank, the heating member is placed in the resin nozzle, and the substrate is held in a vicinity of the opening.

8. A method for producing a resin thin film according to claim 7, wherein gas is introduced into the resin nozzle after the liquid resin material is allowed to adhere to the substrate.

9. A method for producing a resin thin film according to claim 1, further comprising curing the liquid resin material after allowing the liquid resin material to adhere to the substrate.

10. A method for producing a resin thin film according to claim 9, wherein the liquid resin material is cured outside of the vacuum tank.

11. A method for producing a resin thin film, using an apparatus for producing a resin thin film comprising:
a heating member for evaporating a liquid resin material by heating;
a holder for holding a substrate, upon which the evaporated resin material condenses, at a predetermined position;
a vacuum tank housing the heating member, the substrate, and the holder;
a primary tank portion including a pressure tank and a resin material cup disposed in the pressure tank and storing the liquid resin material;
a supply pipe for supplying the liquid resin material stored in the resin material cup to the heating member;
a valve provided in the supply pipe; and
a flowmeter for measuring a flow amount of the liquid resin material flowing in the supply pipe, the method comprising:
increasing a pressure in the pressure tank when the valve is closed;
opening the valve and sending the liquid resin material in the resin material cup to the heating member under pressure through the supply pipe; and
closing the valve when the flow amount of the liquid resin material obtained by the flowmeter reaches a predetermined value.

12. An apparatus for producing a resin thin film, comprising:
a heating member for evaporating a liquid resin material by heating;
a holder for holding a substrate, upon which the evaporated resin material condenses, at a predetermined position;
a vacuum tank housing the heating member, the substrate, and the holder;
a primary tank portion including a pressure tank and a resin material cup disposed in the pressure tank and storing the liquid resin material;
a supply portion including a supply tank storing the liquid resin material temporarily, and a piston disposed in the supply tank and displaced in correspondence with a volume of the liquid resin material in the supply tank;
a primary side supply pipe for sending the liquid resin material from the resin material cup to the supply tank; and
an evaporation side supply pipe for sending the liquid resin material from the supply tank to the heating member,
wherein the liquid resin material is quantified by a stroke of the piston, and the quantified liquid resin material is sent to the heating member through the evaporation side supply pipe.

13. An apparatus for producing a resin thin film according to claim 12, wherein the liquid resin material in the resin material cup is sent to the supply tank under pressure through the primary side supply pipe by increasing a pressure in the pressure tank.

14. An apparatus for producing a resin thin film according to claim 13, wherein the pressure in the pressure tank is increased by introducing gas into the pressure tank.

15. An apparatus for producing a resin thin film according to claim 14, wherein the gas is inert gas.

16. An apparatus for producing a resin thin film according to claim 12, further comprising a regulator with a detection error precision of ±2% or less, for detecting a pressure in the pressure tank.

17. An apparatus for producing a resin thin film according to claim 12, wherein an inner diameter of the primary side supply pipe is larger than an inner diameter of the evaporation side supply pipe.

18. An apparatus for producing a resin thin film according to claim 12, wherein the primary side supply pipe and the evaporation side supply pipe are connected to a bottom surface of the supply tank.

19. An apparatus for producing a resin thin film according to claim 12, wherein the stroke of the piston is adjustable.

20. An apparatus for producing a resin thin film according to claim 12, further comprising a flowmeter for measuring a flow amount of the liquid resin material passing through the primary side supply pipe.

21. An apparatus for producing a resin thin film according to claim 20, wherein a supply of the liquid resin material by the primary side supply pipe is suspended when the flow amount of the liquid resin material obtained by the flowmeter reaches a predetermined value.

22. An apparatus for producing a resin thin film according to claim 12, wherein the heating member has a conical surface, the conical surface is set with an apex thereof placed upward, and the liquid resin material is supplied in a vicinity of the apex.

23. An apparatus for producing a resin thin film according to claim 22, wherein the conical surface is a circular conical surface.

24. An apparatus for producing a resin thin film according to claim 12, further comprising a discharge nozzle at a downstream end of the evaporation side supply pipe, wherein the discharge nozzle has a plurality of holes for discharging the liquid resin material.

25. An apparatus for producing a resin thin film according to claim 12, wherein the liquid resin material is supplied to the heating member as liquid droplets.

26. An apparatus for producing a resin thin film according to claim 12, wherein the liquid resin material is supplied to the heating member in an atomized form.

27. An apparatus for producing a resin thin film according to claim 12, wherein the evaporation side supply pipe is cooled.

28. An apparatus for producing a resin thin film according to claim 12, further comprising a resin nozzle having an opening,
wherein the resin nozzle is placed in the vacuum tank, the heating member is placed in the resin nozzle, and the substrate is held in a vicinity of the opening.

29. An apparatus for producing a resin thin film according to claim 28, wherein the resin nozzle includes a porous body having continuous pores between the heating member and the substrate.

30. An apparatus for producing a resin thin film according to claim 12, further comprising a mask for limiting a region where the resin material adheres to the substrate.

31. An apparatus for producing a resin thin film according to claim 12, wherein an inner wall surface of the vacuum tank is heated to a temperature equal to or higher than an evaporation temperature of the resin material.

32. An apparatus for producing a resin thin film according to claim 28, wherein the resin nozzle is heated to a temperature equal to or higher than an evaporation temperature of the resin material.

33. An apparatus for producing a resin thin film according to claim 29, wherein the porous body is heated to a temperature equal to or higher than an evaporation temperature of the resin material.

34. An apparatus for producing a resin thin film according to claim 30, wherein the mask is heated to a temperature equal to or higher than an evaporation temperature of the resin material.

35. An apparatus for producing a resin thin film according to claim 28,
wherein the vacuum tank includes a vacuum pump, and
a suction port leading to the vacuum pump in the vacuum tank, the opening of the resin nozzle, and the substrate being placed substantially in a straight line.

36. An apparatus for producing a resin thin film according to claim 28, wherein it is possible to supply gas to the resin nozzle.

37. An apparatus for producing a resin thin film according to claim 12, further comprising a curing portion for curing the liquid resin material adhering to the substrate.

38. An apparatus for producing a resin thin film according to claim 37, wherein the curing portion is placed outside of the vacuum tank.

39. An apparatus for producing a resin thin film, comprising:
a heating member for evaporating a liquid resin material by heating;
a holder for holding a substrate, upon which the evaporated resin material condenses, at a predetermined position;
a vacuum tank housing the heating member, the substrate, and the holder;
a primary tank portion including a pressure tank and a resin material cup disposed in the pressure tank and storing the liquid resin material;
a supply pipe for supplying the liquid resin material stored in the resin material cup to the heating member; and
a flowmeter for measuring a flow amount of the liquid resin material flowing in the supply pipe,
wherein a supply of the liquid resin material by the supply pipe is suspended when the flow amount of the liquid resin material obtained by the flowmeter reaches a predetermined value.
